# EUROPEAN PATENT SPECIFICATION

(11) **EP 3 018 822 B1**
(45) Date of publication and mention of the grant of the patent: **03.07.2019**
(21) Application number: 15183173.2
(22) Date of filing: 31.08.2015
(51) Int. Cl.: G01S 3/78, H01L 31/054, H02S 20/32

(54) **MICRO-CONCENTRATOR SOLAR ARRAY USING MICRO- ELECTROMECHANICAL SYSTEMS (MEMS) BASED**
MIKROKONZENTRATORSOLARANLAGE MIT REFLEKTOREN AUF BASIS VON MIKROELEKTROMECHANISCHEN SYSTEMEN (MEMS)
RÉSEAU DE CELLULES SOLAIRES À MICRO-CONCENTRATEUR UTILISANT DES RÉFLECTEURS BASÉS SUR DES SYSTÈMES MICRO-ÉLECTROMÉCANIQUES (MEMS)

(30) Priority: 04.11.2014 US 201414532356
(43) Date of publication of application: 11.05.2016
(73) Proprietor: The Boeing Company, Chicago, IL 60606-1596 (US)
(72) Inventor: SINGER, Scott Benjamin, Chicago, IL 60606-2016 (US); KRUT, Dimitri D., Chicago, IL 60606-2016 (US); KARAM, Nasser H., Chicago, IL 60606-2016 (US)
(74) Representative: Cabinet Plasseraud

(56) References cited:
- EP-A1- 2 911 208
- WO-A1-2009/121174
- WO-A2-2010/065794
- DE-A1-102009 037 083
- US-A1- 2005 034 751
- US-A1- 2009 188 545
- US-A1- 2014 137 924

## Description

### BACKGROUND INFORMATION

### 1. Field:

The disclosed system and method relate to a micro-concentrator solar array and, more particularly, to a micro-concentrator solar array using micro-electromechanical systems (MEMS) based reflectors to track light onto a solar cell.

### 2. Background:

Electric power generation from solar or photovoltaic cells has experienced significant interest recently. Solar cells convert light energy, typically from the sun, into electrical energy. The light intensity on a solar cell may be referred to as the number of suns, where a 1-sun concentration corresponds to standard illumination at 1 kW/m2.

Widespread adoption of solar cells for power generation may require further breakthrough in both the cost and efficiency. For example, many solar power generators currently available employ flat-plate technologies, where the solar cells operate under 1-sun concentration. These types of solar power generators have relatively low solar-to-power conversion efficiencies, are relatively large and cumbersome, and tend to transform a majority of light energy into heat. Moreover, these solar power generators may result in relatively long charge times in practice. Specifically, sometimes charging equipment using the solar power generator may take many hours, even over several days. In addition to the long charge times, the position of the solar power generators needs to be adjusted periodically during the day in order to accommodate the changing position of the sun in the sky. Therefore, it would be desirable to have a method and apparatus that take into account at least some of the issues discussed above, as well as other possible issues.

Examples of known solar arrays are disclosed in WO2010065794, US20090188545, DE102009037083, US20050034751, WO2009121174, US20140137924.

### SUMMARY

In view of the above, the disclosure proposes an apparatus, a method and a system as claimed respectively in claims 1, 8, 12.

### BRIEF DESCRIPTION OF THE DRAWINGS

The novel features believed characteristic of the illustrative embodiments are set forth in the appended claims. The illustrative embodiments, however, as well as a preferred mode of use, further objectives and advantages thereof, will best be understood by reference to the following detailed description of an illustrative embodiment of the present disclosure when read in conjunction with the accompanying drawings, wherein:
**Figure 1** is an illustration of the disclosed micro-concentrator solar array including a plurality of solar cells arranged on a coverglass and a plurality of micro-electromechanical systems (MEMS) based reflectors arranged on a substrate;
**Figure 2** is a cross-section of the micro-concentrator solar array taken along section line 2-2 in **Figure 1****;**
**Figure 3** is a perspective view of a portion of the coverglass shown in **Figure 1****,** where receivers may be used to mount the solar cells to the coverglass;
**Figure 4** is an exemplary process flow diagram illustrating a method of adjusting the reflectors shown in **Figure 1****;**
**Figure 5** is an illustration of an alternative aspect of the micro-concentrator solar array;
**Figure 6** is an illustration of a solar array system in the form of a block diagram in accordance with an illustrative embodiment;
**Figure 7** is an illustration of a solar array in accordance with an illustrative embodiment;
**Figure 8** is an illustration of a solar array system in accordance with an illustrative embodiment;
**Figure 9** is an illustration of a cross-sectional view of a solar array in accordance with an illustrative embodiment;
**Figure 10** is an illustration of a process for focusing light onto a plurality of solar cells in the form of a flowchart in accordance with an illustrative embodiment;
**Figure 11** is an illustration of a process for focusing light onto a solar cell in the form of a flowchart in accordance with an illustrative embodiment; and
**Figure 12** is an illustration of a process for tracking sunlight using a solar array in the form of a flowchart in accordance with an illustrative embodiment.

### DETAILED DESCRIPTION

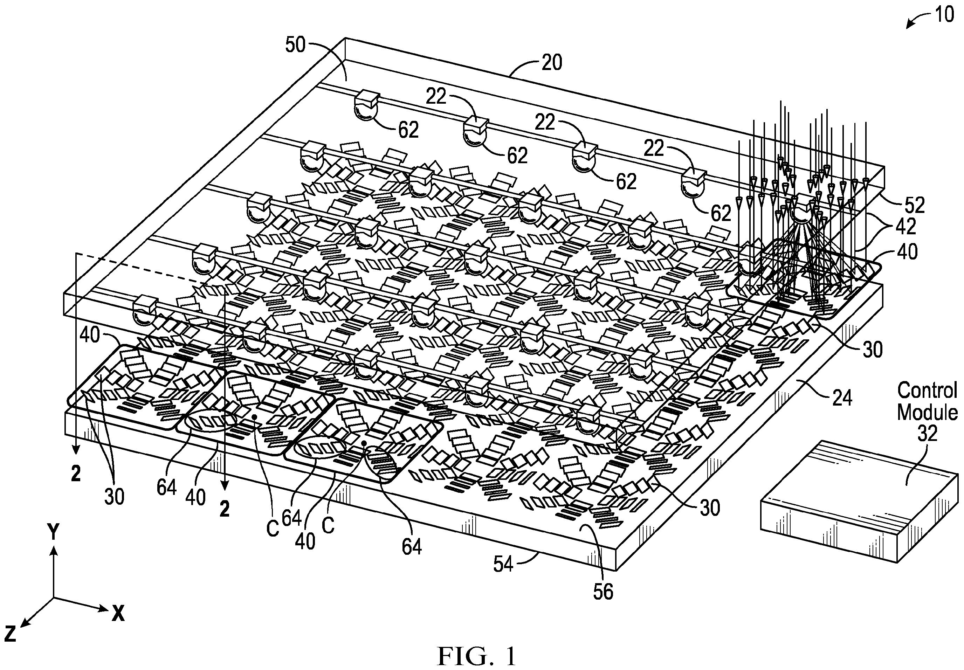

As shown in **Figure 1****,** the micro-concentrator solar array **10** according to an aspect of the disclosure may include a coverglass **20,** a plurality of solar cells **22,** a substrate **24,** a plurality of micro-electromechanical systems (MEMS) based mirrors or reflectors **30,** and a control module **32.** In the exemplary aspect as shown, the solar cells **22** may be arranged in a 5x5 array upon the coverglass **20,** which results in a total of twenty-five solar cells **22** included within the micro-concentrator solar array **10.** However, those skilled in the art will appreciate that the solar array **10** may include any number of solar cells **22.** An array **40** of reflectors **30** may be associated with each solar cell **22.** Each reflector **30** included within the array **40** may be positioned relative to the associated solar cell **22** in order to focus or reflect a plurality of light beams **42** generated by a light source (not illustrated) onto the solar cell **22.**

The light source may be any type of radiating energy source such as, for example, man-made lighting in a building, or the sun. Each reflector **30** may be selectively tiltable such that if the position of the light source changes, each reflector **30** located within the associated array **40** may be tilted accordingly in order to track the changed position of the light source relative to the associated solar cell **22.** For example, if the light source is the sun, then each reflector **30** located within the associated array **40** may be tilted accordingly in order to track the changing position of the sun throughout the day. The tilting of the reflectors **30** relative to the light source is described in greater detailed below.

The micro-concentrator solar array **10** may be used in any application where light energy, typically from the sun, may be converted into electrical energy. For example, **Figure 1** illustrates a single micro-concentrator solar array **10** for purposes of convenience and clarity. The single micro-concentrator solar array **10** in **Figure 1** may be used in relatively compact applications such as, for example, a slim-line pocket-sized portable power generator. However, the single micro-concentrator solar array **10** may be electrically connected or ganged with other micro-concentrator solar arrays in order to create a two-dimensional or tiled array of multiple micro-concentrator arrays (not illustrated). The two-dimensional array of multiple micro-concentrator arrays may be used in relatively large-scale applications such as, for example, a terrestrial portable power generator, an unmanned aerial vehicle (UAV), or a satellite.

The coverglass **20** may be constructed of any transparent material that allows for the light beams **42** to pass through such as, for example, glass, plastic, or silicon dioxide. The substrate **24** may be used to support or mount the reflectors **30.** In one non-limiting aspect, the substrate **24** may be constructed of fused silica.

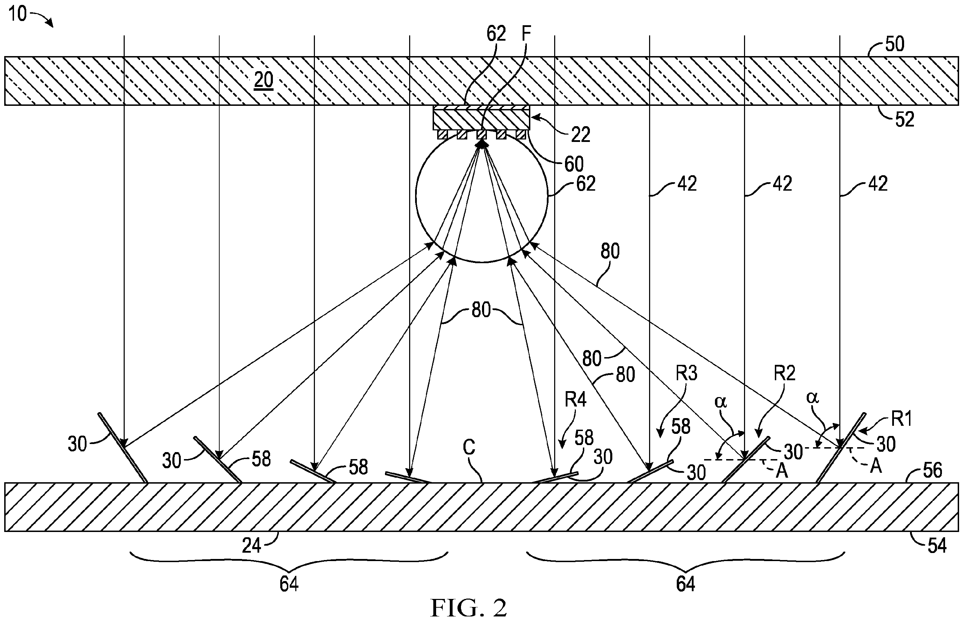

**Figure 2** is a cross-section of a portion of the coverglass **20,** a single solar cell **22,** the substrate **24,** and the reflectors **30** associated with the single solar cell **22,** taken along section line 2-2 in **Figure 1****.** Referring generally to **Figures 1-2****,** the coverglass **20** may include an outer surface **50** and an inner surface **52,** and the substrate **24** may also include an outer surface **54** and an inner surface **56.** In one aspect, an optional anti-reflection coating may be applied to the inner and outer surfaces **52, 50,** of the coverglass **20.** The inner surface **52** of the coverglass **20** generally opposes the inner surface **56** of the substrate **24.** Each solar cell **22** may include a front surface **60** and a back surface **63** (seen in **Figure 2**)**.** The back surface **63** of the solar cell **22** may be affixed to or carried by the inner surface **52** of the coverglass **20.**

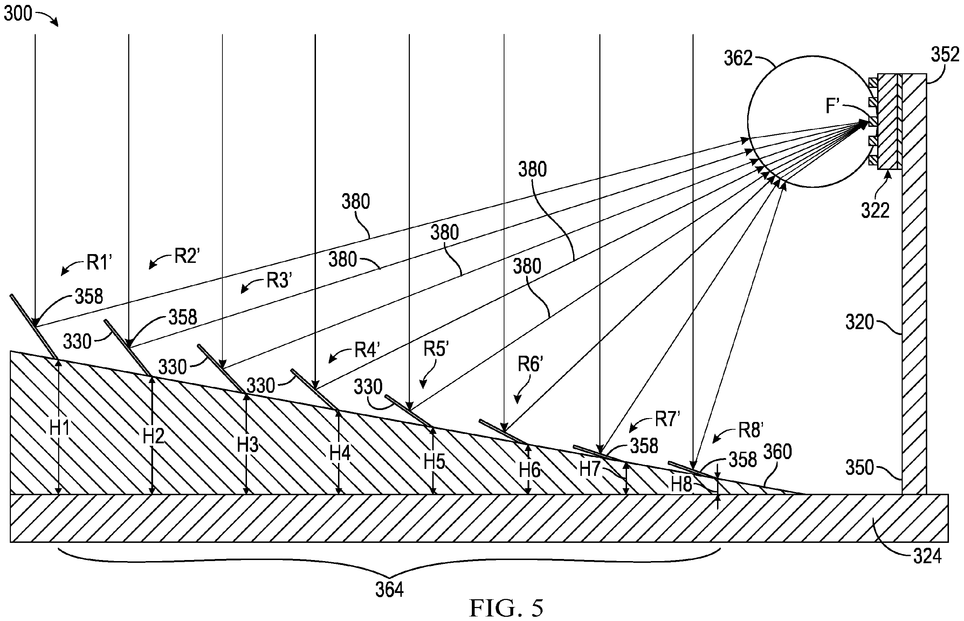

Although **Figures 1-2** show the coverglass **20** located above the substrate **24,** it is to be understood that this illustration is merely exemplary in nature. Those skilled in the art will appreciate that the coverglass **20** may be located relative to the substrate **24** in any position where the light beams **42** may be directed upon the reflectors **30** and onto the solar cells **22.** For example, in another aspect, the micro-concentrator solar array **10** may be rotated by ninety degrees, and the coverglass **20** may be located to the right of the substrate **24.** Moreover, in some aspects the coverglass **20** may be omitted. Instead, the solar cells **22** may be mounted on a corresponding support member **320** shown in **Figure 5****,** and is described in greater detail below.

Referring to **Figure 1****,** in one aspect the reflectors **30** may be arranged in a two-dimensional pattern upon the inner surface **56** of the substrate **24.** Specifically, each array **40** may include multiple sub-arrays **64** of reflectors **30.** In the aspect as shown in **Figure 1****,** each sub-array **64** may include four reflectors **30,** however it is to be understood that any number of reflectors **30** may be included within the sub-array **64** as well. In the non-limiting aspect as shown in **Figure 1****,** each sub-array **64** of reflectors **30** may be arranged in a radially outward direction with respect to a central point C of the array **40.** The specific solar cell **22** associated with the array **40** may be positioned along the inner surface **52** of the coverglass **20** to generally oppose the central point C. Although **Figure 1** illustrates each sub-array **64** of reflectors **30** arranged in a radially outward direction, those skilled in the art will appreciate that this illustration is merely exemplary in nature. For example, in another aspect, the reflectors **30** may be arranged in a rectangular pattern.

The solar cells **22** may also be referred to as photovoltaic cells. The solar cells **22** may be any device configured to convert solar radiation into electrical energy. In one exemplary aspect, the micro-concentrator solar array **10** may include a secondary optical device **62** associated with each solar cell **22.** However, it is to be understood that the secondary optical device **62** may be omitted in some aspects. Referring to **Figure 2****,** the secondary optical device **62** may be positioned along the front surface **60** of the solar cell **22.** The secondary optical device **62** may be used to focus the light beams **42** reflected off of each reflection surface **58** of the reflectors **30** and onto a focal point F located on the solar cell **22.** Thus, the solar cell **22** may receive an increased amount of light energy if the secondary optical device **62** is included. The secondary optical device **62** may be any type of concentrator or lens for focusing light from the reflectors **30** onto the focal point F of the solar cell **22** such as, for example, a concave lens, a convex lens, a parabolic lens, or a Fresnel lens.

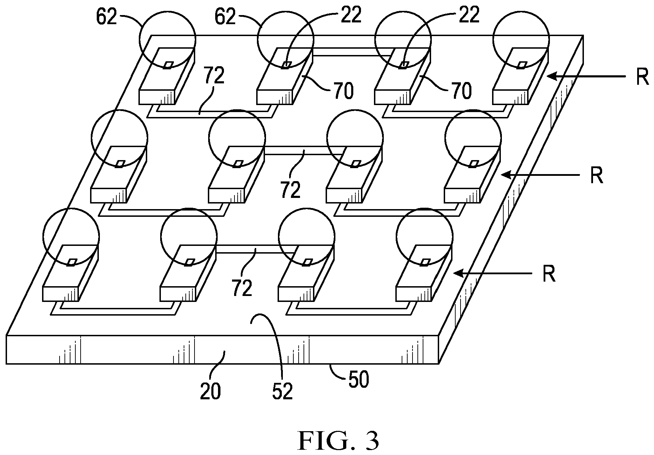

**Figure 3** illustrates a portion of the inner surface **52** of the coverglass **20,** where the coverglass **20** has been rotated one hundred and eighty degrees such that the inner surface **52** of the coverglass **20** is facing upwardly. In the aspect as shown in **Figure 3****,** the solar cells **22** are each mounted to and electrically connected to a corresponding receiver **70.** Each receiver **70** may be mounted to the inner surface **52** of the coverglass **20.** The receivers **70** may be used as an alternative approach for mounting the solar cells **22** to the coverglass **20.** In one aspect, the receivers **70** may include a heat sink or other device (not illustrated) for dissipating heat generated by the solar cell **22.**

A plurality of interconnects **72** may be used to electrically connect two or more of the receivers **70** to one another. In one aspect, the interconnects **72** may be constructed from an electrically conductive material such as, for example, metal. The interconnects **72** may be located along the inner surface **52** of the coverglass **20,** and may be used to electrically connect the receivers **70** in any number of configurations in order to provide the voltage and current required for a specific application. For example, in the aspect as shown in **Figure 3****,** the interconnects **72** may be used to connect the receivers **70** located in a single row **75** to one another in a series configuration. However, the interconnects **72** may also be used to connect each row **75** of receivers **70** to one another in a parallel configuration (the parallel connection is not illustrated in **Figure 3**). Although **Figure** 3 illustrates the receivers **70** located in each row **75** connected to one another in a series configuration, it is to be understood that the receivers **70** may be connected to one another in a parallel configuration as well. Moreover, although each row **75** of receivers **70** are described as being connected to one another in a parallel configuration, it is to be understood that the rows **75** of receivers **70** may be connected together in a series configuration as well.

Referring to **Figure 2****,** the reflectors **30** may be any type of MEMS-based device having an elliptical, cylindrical, rectangular, square, or randomly shaped micro-mirror or micro-reflector configured to reflect light. An actuation device (not illustrated) may be provided for each reflector **30.** The actuation device may be used to adjust an amount of tilt of an associated reflector **30.** Specifically, as seen in **Figure 2****,** the amount of tilt of each reflector may be measured by an angle α. The angle α may be measured between the reflection surface **58** of the reflector **30** and an axis A-A. The axis A-A may be oriented generally parallel with respect to the substrate **24.** A reflected light beam **80** may represent the light reflected off of the reflection surface **58** of the reflector **30** and directed towards the secondary optical device **62.** If the secondary optical device **62** is omitted, then the reflected light beam **80** may be directed towards the focal point F located on the solar cell **22.** It should be noted that while the reflector **30** is described as being tiltable or rotatable in the x-axis direction (the x-axis is illustrated in **Figure 1**), the reflector **30** may be tilted about a second axis of rotation as well. Specifically, in one aspect, the angle α of the reflector **30** may be tilted in the z-axis direction (the z-axis is illustrated in **Figure 1**) as well. Thus, the reflector **30** may be tilted using either single-axis tracking (i.e., adjusted in either the x-axis or the z-axis) or dual-axis tracking (i.e., adjusted in both the x-axis and the z-axis). In other words, the reflectors may be tiltable or rotatable about either one axis of rotation or two axes of rotation.

The actuation device (not illustrated) may be any type of device capable of adjusting the angle α of the associated reflector **30.** For example, in one non-limiting aspect, the actuating devices may be comb-drive actuators that use static electromagnetic potential for actuation. In another aspect, the actuating devices may be a rotational actuator. One commercially available example of the rotational actuator is the 4-quadrant 2-axis actuators manufactured by Mirrorcle Technologies of Richmond, California.

Referring to both **Figures 1-2****,** the angle α of the reflectors **30** may be adjusted by applying a specific or unique amount of voltage to each of the actuation devices (not illustrated). For example, with reference to **Figure 2****,** the reflector R1 located to the far right may be tilted at a different angle α when compared to the angles α of the remaining reflectors R2, R3 and R4 located within the sub-array **64.** Each reflector **30** may be tilted at a different angle α based on the reflector's **30** position relative to the focal point F of the corresponding solar cell **22.** Thus, a unique amount of voltage may be applied to the actuation device associated with each reflector **30** in order to tilt each reflector **30** by a specific amount.

In one approach, the control module **32** may have a voltage-tilt curve stored in memory. In one aspect, the voltage-tilt curve may be stored in memory as either a lookup table or a polynomial fit to voltage-tilt data. The voltage-tilt curve may include a plurality of unique voltage values that are each associated with different values of the angle α of the reflector **30.** It should be noted that the voltage-tilt curve may be common to all of the reflectors **30** located within the micro-concentrator solar array **10.** The memory of the control module **32** may also store the position of all of the reflectors **30** relative to the corresponding solar cell **22** as well.

The control module **32** may determine the unique amount of voltage applied to each reflector **30** using the following approach. First, the control module **32** may calculate the angle α of the reflectors **30.** In the example as described, the control module **32** calculates the angle α of the reflector R1 to the far right as shown in **Figure 2****.** The control module **32** may calculate the angle α of the reflector R1 based on the position of the reflector R1 relative to the corresponding solar cell **22** (stored in memory of the control module **32**), and an angle θ of the light beams **42.** The angle θ of the light beams **42** may be measured with respect to the coverglass **20.** The angle θ of the light beams **42** may be a known value stored in memory of the control module **32.** The value of the angle θ of the light beams **42** stored in memory may be updated as the position of a light source (e.g., the sun) changes. Once the control module **32** calculates the angle α of the reflector R1, the control module **32** may then obtain the unique amount of voltage applied to the reflector R1 using the voltage tilt-curve. For example, if the control module **32** determines that the angle α of the reflector R1 should be fifteen degrees, then the control module **32** obtains the unique amount of voltage associated with an angle of fifteen degrees from the voltage-tilt curve stored in memory of the control module **32.** Finally, the control module **32** may apply the unique amount of voltage obtained from the voltage-tilt curve to the actuation device associated with the reflector R1.

Referring to **Figures 1-3****,** the control module **32** may refer to, or be part of, an application specific integrated circuit (ASIC), an electronic circuit, a combinational logic circuit, a field programmable gate array (FPGA), a processor (shared, dedicated, or group) that executes code, or a combination of some or all of the above, such as in a system-on-chip. The control module **32** may be in operative communication with each of the solar cells **22** and the reflectors **30.** Specifically, the control module **32** may be in communication with all of the solar cells **22** located within the micro-concentrator solar array **10** through the interconnects **72** located along the coverglass **20** shown in **Figure 3** (the connection between the interconnects **72** and the control module **32** is not illustrated in the figures).

The control module **32** may include control logic for monitoring the electrical output generated by all of the solar cells **22** located within the micro-concentrator solar array **10.** The electrical output measured by the control module **32** may be, for example, voltage, current, or power generated by the solar cells **22.** The control module **32** may monitor the electrical output generated by all of the solar cells **22** located within the micro-concentrator solar array **10** at a predetermined time interval. The predetermined time interval may be any set amount of time such as, for example, every thirty seconds, every minute, or every five minutes.

In the illustration as shown in **Figure 2****,** the reflectors **30** are tilted at their ideal angles α such that the reflected light beams **80** are each directed towards the focal point F located on the solar cell **22.** The control module **32** may store an ideal output value within memory. The ideal output value represents the electrical output of the solar cells **22** (e.g., voltage, current, power, etc.) when the reflectors **30** are tilted at their ideal angles. **Figure 2** illustrates the light source (e.g., the sun) directing the light beams **42** in a direction generally perpendicular to the coverglass **20** and the substrate **24.** However, as the sun moves throughout the sky throughout the day, the direction of the light beams **42** changes accordingly. Thus, the position of the light beams **80** reflected off of the reflection surface **58** of each reflector **30** may also change. As a result, the reflected light beams **80** are eventually reflected away from the focal point F of the corresponding solar cell **22.** Focusing light upon the focal point F of a corresponding solar cell **22** may maximize the amount of electrical output generated by the solar cell **22.** As the reflected light beams **80** are directed away from the focal point F of the corresponding solar cell **22,** less light energy may be received by the solar cell **22.** As a result, the electrical output generated by the solar cell **22** is decreased.

Referring to **Figures 1-2****,** the control module **32** monitors the electrical output generated by all of the solar cells **22** located within the micro-concentrator solar array **10** at the predetermined time interval. The control module **32** also includes control logic for comparing the electrical output generated by the solar cells **22** with a threshold value. The threshold value may represent an electrical output generated by all of the solar cells **22** that is less than the ideal output value. For example, in one non-limiting aspect, the threshold value may be about ninety-five percent of the ideal output value.

The control module **32** may include circuitry or control logic for applying the unique amount of voltage to each of the actuation devices (not illustrated) associated with the reflectors **30** if the electrical output generated by all of the solar cells **22** is below the threshold value. Specifically, once the electrical output generated by the solar cells **22** drops below a threshold value, then the control module **32** may apply the unique amount of voltage to each of the actuation devices (not illustrated). The reflectors **30** may be re-positioned such that the light beams **80** reflected off of the reflection surface **58** of each reflector **30** may be directed back towards the focal point F of the corresponding solar cell **22.** In one aspect, the control module **32** may include control logic for repositioning the reflectors **30** towards the focal point F of the corresponding solar cell **22** by first stepping through a plurality of pre-programmed reflector positions stored in memory. Each pre-programmed reflector position corresponds with a specific position of the light source. For example, if the light source is the sun, then each pre-programmed reflector position stored in memory of the control module **32** may correspond with the different positions of the sun in the sky. The control module **32** may step though the pre-programmed reflector positions until the reflectors **30** align and focus the light beams **80** towards the focal point F of the solar cell **22.**

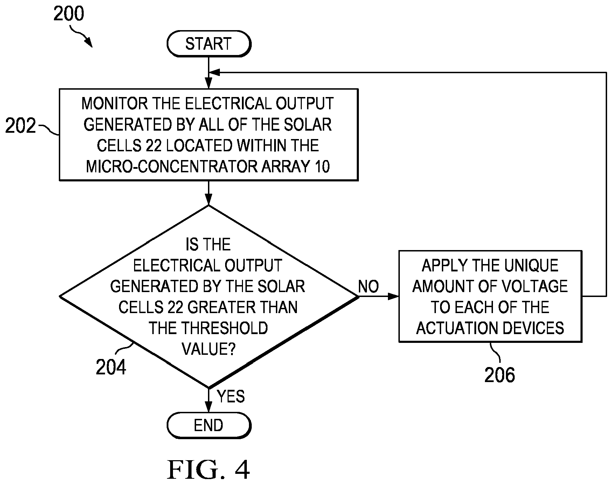

**Figure 4** is a process flow diagram illustrating an exemplary method **200** of adjusting the tilt of the reflectors **30.** Referring generally to **Figures 1-4****,** method **200** may begin at block **202,** where the control module **32** monitors the electrical output generated by all of the solar cells **22** located within the micro-concentrator solar array **10.** The electrical output measured by the control module **32** may be, for example, voltage, current, or power generated by the solar cells **22.** Method **200** may then proceed to block **204.**

In block **204,** the control module **32** compares the electrical output generated by all of the solar cells **22** located within the micro-concentrator solar array **10** with the threshold value. If the electrical output is equal to or greater than the threshold value, then method **200** may then terminate. However, if the electrical output is less than the threshold value, then method **200** may proceed to block **206.**

In block **206,** the control module **32** may apply the unique amount of voltage to each of the actuation devices (not illustrated). As discussed above, applying the unique amount of voltage to each of the actuation devices may reposition each of the reflectors **30** such that the light beams **80** reflected off of the reflection surface **58** of each reflector **30** may be directed back towards the focal point F of the corresponding solar cell **22.** Method **200** may then return to block **202.**

**Figure 5** is a cross-section of an alternative aspect of a micro-concentrator solar array **300,** illustrating a single solar cell **322** and a sub-array **364** of reflectors **330** associated with the solar cell **322.** In the aspect as shown in **Figure 5****,** the reflectors **330** may be supported by a substrate **324.** A corresponding support member **320** may be attached or otherwise affixed to the substrate **324.** Specifically, the support member **320** includes a first end **350** and a second end **352.** The first end **350** of the support member **320** may be affixed to the substrate **324.** The solar cell **322** may be affixed to the second end **352** of the support member **320.** It should be noted that the aspect as shown in **Figure 5** does not require a coverglass, and instead the support member **320** may be used to carry the solar cell **322.** Although **Figure 5** illustrates a single solar cell **322,** those skilled in the art will appreciate that the solar cell **322** may be part of an array of multiple solar cells. For example, the substrate **324** may include multiple support members **320.** Each support member **320** may carry a solar cell **322.** Also, while **Figure 5** illustrates a single sub-array **364** of the reflectors **330,** it is to be understood that multiple sub-arrays **364** of reflectors **330** may surround the solar cell **322.**

The substrate **324** may include a ramped or inclined inner surface **360.** The reflectors **330** may be positioned along the inner surface **360** of the substrate **324.** In the non-limiting aspect as shown, the sub-array **364** includes eight reflectors R1'-R8', where the reflector R1' may be the reflector **330** located the furthest away from the solar cell **322,** and the reflector R8' may be the reflector **330** located closest to the solar cell **322.** The inner surface **360** of the substrate **324** may be angled such that the reflector R1' may be positioned at a vertical height HI, the reflector R2' may be positioned at a vertical height H2, and the remaining reflectors R3'-R8' may be positioned accordingly.

The vertical heights H1-H8 of the reflectors R1'-R8' may be graduated accordingly such that light reflected off of one of the reflectors **330** in the sub-array **364** does not generally interfere with another reflector **330** located downstream. For example, the vertical height H1 of the reflector R1' is greater than the vertical heights of the remaining reflectors R2'-R8'. Thus, the reflector R1' may be elevated such that a beam of light **380** reflected off a reflection surface **358** of the reflector R1' does not interfere or intersect with any of the remaining reflectors R2'-R8' located within the sub-array **364.** Instead, the beam of light **380** reflected off the reflection surface **358** may be directed towards a secondary optical device **362** and onto a focal point F' located on the solar cell **322.**

Referring generally to **Figure 1-5****,** the disclosed micro-concentrator solar array **10** provides a relatively compact and efficient approach for converting light into electrical energy. In particular, the disclosed micro-concentrator solar array **10** provides an approach for adjusting the MEMS based reflectors (e.g., the reflectors **30** shown in **Figures 1-3** or the reflectors **330** shown in **Figure 5**) based on the position of a moving light source (not illustrated). For example, if the light source is the sun, the reflectors may track the position of the sun throughout the sky. The reflectors may then reflect the light from the sun onto the focal point of a corresponding solar cell. Therefore, if the micro-concentrator solar array **10** is part of a solar power generator, then a user does not generally need to reposition the solar power generator periodically during the day in order to accommodate the changing position of the sun within the sky. Moreover, many solar power generators currently available employ flat-plate technologies, where the solar cells operate under 1-sun concentration. In contrast, the disclosed micro-concentrator solar array **10** uses the reflectors in order to concentrate light onto the solar cells. In one aspect, the disclosed solar cells may operate between about 5-suns to about 500-suns concentration. Thus, the disclosed micro-concentrator solar array **10** may employ smaller solar cells that require less space. The disclosed micro-concentrator array **10** may also provide higher solar-to-power conversion efficiencies, and transform less of light energy into heat when compared to the technologies currently available. While the forms of apparatus and methods herein described constitute preferred aspects of this invention, it is to be understood that the invention is not limited to these precise forms of apparatus and methods, and the changes may be made therein without departing from the scope of the invention.

The illustrative embodiments recognize and take into account that it may be desirable to have a method and apparatus for controlling a solar array to ensure that the highest concentrations of light are focused onto the solar cells of the solar array at substantially all times. In particular, it may be desirable to have a method and apparatus for ensuring that the solar cells of a solar array generate an electrical output that is at least at a selected threshold or threshold value.

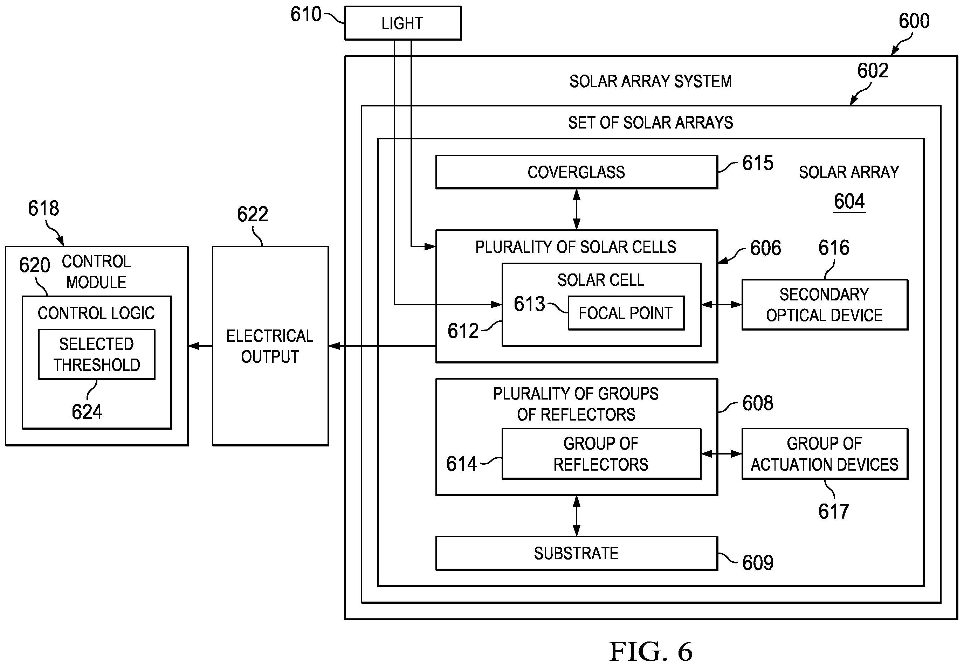

Referring now to **Figure 6****,** an illustration of a solar array system is depicted in the form of a block diagram in accordance with an illustrative embodiment. In this illustrative example, solar array system **600** is depicted. Solar array system **600** may be comprised of set of solar arrays **602.** As used herein, a "set of" items may include one or more items.

In some illustrative examples, each of set of solar arrays **602** may be referred to as a micro-concentrator solar array. In other illustrative examples, each of set of solar arrays **602** may be referred to as a solar panel. In these cases, solar array system **600** may be referred to as a solar panel system. For example, solar array **604** may be an example of one of set of solar arrays **602.** Solar array **604** may be referred to as a micro-concentrator solar array. Micro-concentrator solar array **10** in **Figure 1** may be an example of one implementation for solar array **604.**

As depicted, solar array **604** may be comprised of plurality of solar cells **606** and plurality of groups of reflectors **608.** Plurality of groups of reflectors **608** may be supported by substrate **609.** In some illustrative examples, control electronics may be integrated into substrate **609** for controlling plurality of groups of reflectors **608.** These control electronics may be used to control actuation devices associated with the reflectors in plurality of groups of reflectors **608.**

As used herein, when one component is "associated" with another component, the association is a physical association in the depicted examples. For example, a first component, such as an actuation device, may be considered to be associated with a second component, such as a reflector, by being secured to the second component, bonded to the second component, mounted to the second component, welded to the second component, fastened to the second component, and/or connected to the second component in some other suitable manner. The first component also may be connected to the second component using a third component. Further, the first component may be considered to be associated with the second component by being formed as part of and/or as an extension of the second component.

As used herein, the phrase "at least one of," when used with a list of items, means different combinations of one or more of the listed items may be used and only one of the items in the list may be needed. The item may be a particular object, thing, or category. In other words, "at least one of" means any combination of items or number of items may be used from the list, but not all of the items in the list may be required.

For example, "at least one of item A, item B, and item C" may mean item A; item A and item B; item B; item A, item B, and item C; or item B and item C. In some cases, "at least one of item A, item B, and item C" may mean, for example, without limitation, two of item A, one of item B, and ten of item C; four of item B and seven of item C; or some other suitable combination.

Each group of reflectors in plurality of groups of reflectors **608** may correspond to one of plurality of solar cells **606.** In particular, each of the plurality of group of reflectors **608** may correspond to one of plurality of solar cells **606** by being positioned relative to the corresponding solar cell such that the group of reflectors is capable of reflecting light **610** towards the corresponding solar cell. Light **610** may take the form of, for example, without limitation, a beam of light that is comprised of a plurality of rays of light. Light **610** may be natural sunlight, artificial sunlight, or some other type of light.

For example, solar cell **612** may be an example of one of plurality of solar cells **606.** Solar cell **612** may have focal point **613.** Group of reflectors **614** in plurality of groups of reflectors **608** may correspond to solar cell **612.** Group of reflectors **614** may include more than one reflector. Each reflector in group of reflectors may be selectively tiltable about at least one axis such that light **610** may be reflected onto focal point **613** of solar cell **612.** Light **610** may pass through coverglass **615** and be reflected off group of reflectors **614** to be focused onto solar cell **612.** In particular, light **610** may be focused onto focal point **613** of solar cell **612** by group of reflectors **614.**

Solar cell **612** may be associated with coverglass **615.** In one illustrative example, solar cell **612** may be mounted onto coverglass **615.** For example, solar cell **612** may be mounted onto coverglass **615** using an interconnect that is associated with coverglass **615.** Solar cell **612** may be attached to the interconnect in an inverted manner, depending on the implementation. The interconnect may be, for example, a metal interconnect. Any number of interconnects may be present on coverglass **615** for holding plurality of solar cells **606.** For example, a plurality of interconnects may be used for mounting and holding plurality of solar cells **606** on coverglass **615.** In some illustrative examples, bypass diodes may be integrated onto the one or more interconnects on coverglass **615.**

In one illustrative example, each reflector in group of reflectors **614** and each reflector in plurality of groups of reflectors **608** may be implemented using a micro-electromechanical systems (MEMS) based reflector. Each reflector may be, for example, a micro-mirror that is tiltable about at least one axis. Group of actuation devices **617** may be associated with group of reflectors **614.** Each actuation device in group of actuation devices **617** may be controlled by a voltage. This voltage may also be referred to as an actuation voltage. In some cases, the particular actuation device corresponding to a reflector may be considered part of the overall reflector. In this manner, the reflector may include the structure with the reflective material capable of reflecting light **610,** the actuation device, and in some cases, one or more other components. The structure with the reflective material may be a mirror structure.

In some cases, secondary optical device **616** may be associated with solar cell **612.** For example, secondary optical device **616** may be mounted onto solar cell **612** such that light **610** may be reflected from group of reflectors **614** through secondary optical device **616** to solar cell **612.** Secondary optical device **62** in **Figures 1-2** may be an example of one implementation for secondary optical device **616.** In some cases, secondary optical device **616** may be considered optional.

Control module **618** may be in communication with solar array system **600.** In particular, control module **618** may be in communication with each of set of solar arrays **602.** For example, control module **618** may be in communication with plurality of solar cells **606** and plurality of groups of reflectors **608** of solar array **604.** Control module **618** may be used to control the positioning of each reflector in set of solar arrays **602** such that light **610** may be reflected onto each of the solar cells in set of solar arrays **602.**

Control module **618** may be considered part of the control electronics integrated into substrate **609** or separate from these control electronics. In some cases, control module **618** may be implemented in a manner similar to control module **32** in **Figure 1****.** Using control module **618,** the control electronics in substrate **609,** or a combination of the two, plurality of groups of reflectors **608** may be controlled to achieve high concentrations of light being reflected onto plurality of solar cells **606.**

In one illustrative example, control module **618** may monitor electrical output **622** generated by plurality of solar cells **606** in solar array **604.** Electrical output **622** may be in the form of voltage, current, power, or some other type of electrical output. Control module **618** may include control logic **620.** Control logic **620** may be used to determine when electrical output **622** is below selected threshold **624.** Selected threshold **624** may be selected based on experimentation. Selected threshold **624** may also be referred to as a threshold value.

When electrical output **622** is below selected threshold **624,** control logic **620** may reposition plurality of groups of reflectors **608.** Repositioning plurality of groups of reflectors **608** may include repositioning at least one reflector in plurality of groups of reflectors **608** by tilting the at least one reflector about at least one axis. This repositioning may be implemented, for example, by adjusting the voltage applied to the actuation device corresponding to the at least one reflector. Thus, control module **618** may control the repositioning of at least one reflector in plurality of groups of reflectors **608** with respect to at least one axis when electrical output **622** is below selected threshold **624.**

In this manner, control module **618** having control logic **620** may be used to improve the performance of solar array **604** such that electrical output **622** produced by solar array **604** is sufficiently high. For example, as the direction in which light **610** encounters solar array **604** changes over time, any number of reflectors in plurality of groups of reflectors **608** may need to be repositioned, or tilted differently, to maintain at least selected threshold **624** of electrical output **622** from solar array **604.** The direction in which light **610** encounters solar array **604** may change for a number of different reasons. For example, the location of solar array **604** relative to the source from which light **610** originates may be changed, the location of the source may change relative to the solar array **604,** or some combination thereof. In one illustrative example, control module **618** may be used to control each of the plurality of groups of reflectors in each solar array in set of solar arrays **602** in a similar manner to improve the performance of each of set of solar arrays **602** in solar array system **600.**

The illustration of solar array system **600** in **Figure 6** is not meant to imply physical or architectural limitations to the manner in which an illustrative embodiment may be implemented. Other components in addition to or in place of the ones illustrated may be used. Some components may be optional. Also, the blocks are presented to illustrate some functional components. One or more of these blocks may be combined, divided, or combined and divided into different blocks when implemented in an illustrative embodiment.

For example, in some cases, an individual control module may be associated with each of set of solar arrays **602** instead of control module **618** controlling each of set of solar arrays **602.** In some illustrative examples, a portion of plurality of solar cells **606** may each be associated with a secondary optic device while another portion of plurality of solar cells **606** may not be associated with a secondary optic device.

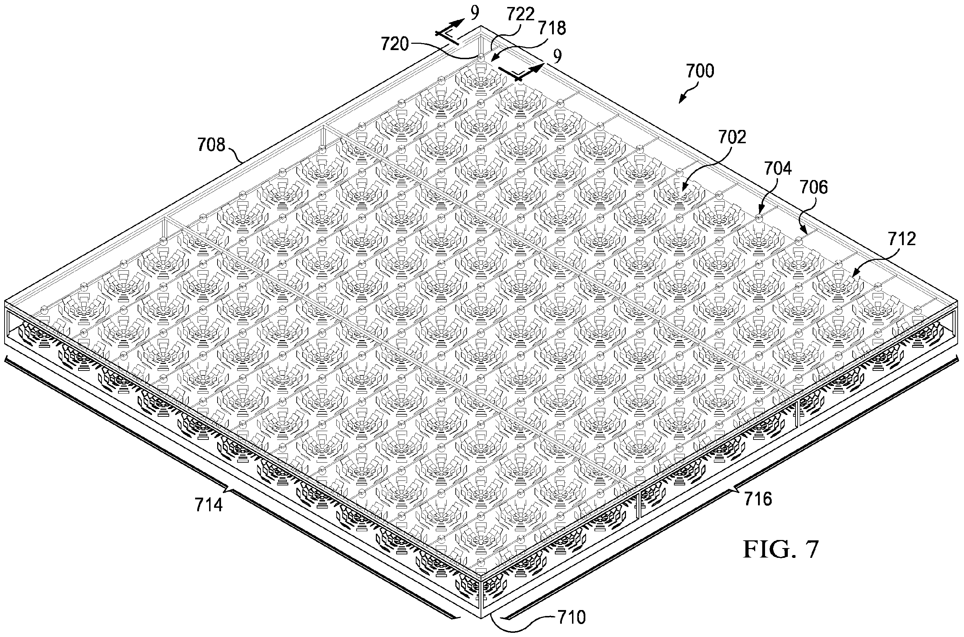

With reference now to **Figure 7****,** an illustration of a solar array is depicted in accordance with an illustrative embodiment. In this illustrative example, solar array **700** may be an example of one implementation for solar array **604** in **Figure 6****.** As depicted, solar array **700** may include plurality of groups of reflectors **702** and plurality of solar cells **704,** which may be examples of implementations for plurality of groups of reflectors **608** and plurality of solar cells **606,** respectively, in **Figure 6****.**

As depicted, plurality of solar cells **704** are connected to plurality of interconnects **706** on coverglass **708.** Plurality of secondary optical devices **712** may be mounted onto plurality of solar cells **704.** In particular, each of plurality of secondary optical devices **712** may be mounted onto a corresponding one of plurality of solar cells **704.**

Plurality of groups of reflectors **702** are supported by substrate **710.** Plurality of groups of reflectors **702** are arranged in rows **714** and columns **716.** Plurality of groups of reflectors **702** may form a 12 by 12 array in this illustrative example.

Group of reflectors **718** may be an example of one of plurality of groups of reflectors **702.** Solar cell **720** may correspond to group of reflectors **718.** Solar cell **720** may be connected to interconnect **722** of plurality of interconnects **706.** Group of reflectors **718** may be configured to reflect a beam of light to focus the reflected beam of light onto solar cell **720.**

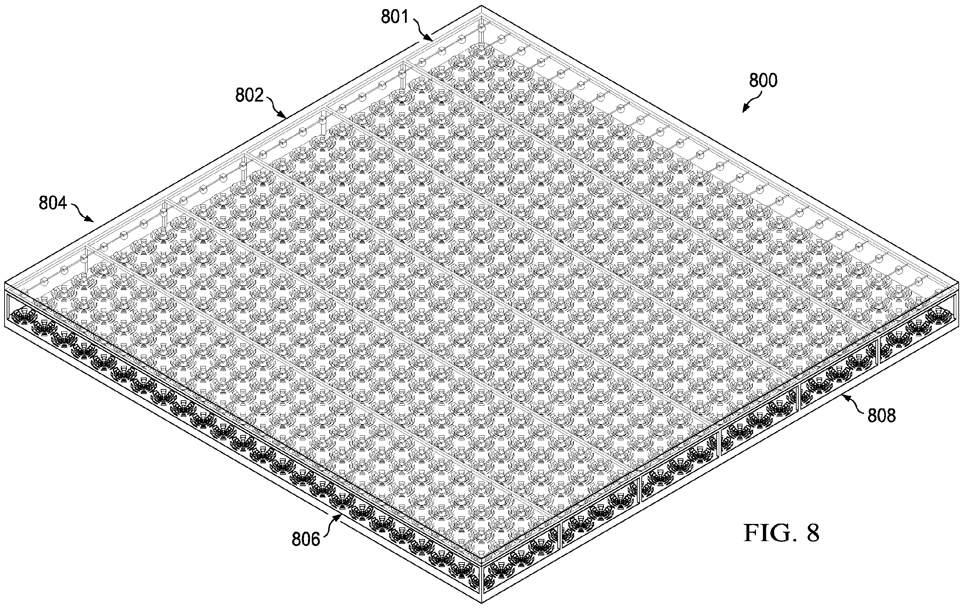

With reference now to **Figure 8****,** an illustration of a solar array system is depicted in accordance with an illustrative embodiment. In this illustrative example, solar array system **800** may be an example of one implementation for solar array system **600** in **Figure 6****.** Solar array system **800** may include set of solar arrays **801.** Set of solar arrays **801** includes solar arrays **802, 804, 806,** and **808.** Each of set of solar arrays **801** may be implemented in a manner similar to solar array **700** in **Figure 7****.**

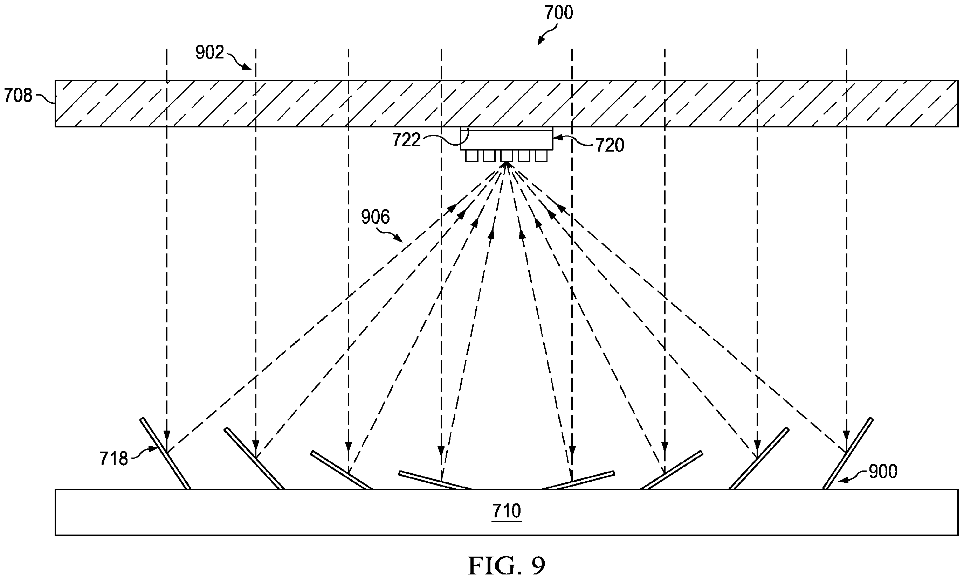

With reference now to **Figure 9****,** an illustration of a cross-sectional view of solar array **700** from **Figure 7** is depicted in accordance with an illustrative embodiment. In this illustrative example, a cross-sectional view of solar array **700** from **Figure 7** is depicted taken in the view of lines **9-9** in **Figure 7****.** However, in this illustrative example, the secondary optical device mounted onto solar cell **720** in **Figure 7** has been optionally excluded.

As depicted, portion **900** of group of reflectors **718** may be seen. Beam of light **902** may pass through coverglass **708** and become incident on group of reflectors **718.** Beam of light **902** is reflected by group of reflectors **718** in the form of reflections **906** that are focused onto a focal point of solar cell **720.** In this illustrative example, beam of light **902** may pass through coverglass **708** at an angle perpendicular to coverglass **708.**

However, the angle at which beam of light **902** passes through coverglass **708** may change over time. A control module, such as control module **618** in **Figure 6****,** may be used to reposition one or more reflectors in group of reflectors **718** to ensure that the electrical output of solar cell **720** is kept at or above a selected threshold.

The illustrations of solar array **700** in **Figures 7** and **9** and solar array system **800** in **Figure 8** are not meant to imply physical or architectural limitations to the manner in which an illustrative embodiment may be implemented. Other components in addition to or in place of the ones illustrated may be used. Some components may be optional.

The different components shown in **Figures 1-4****,** **Figure 5****,** and **Figures 7****-9** may be illustrative examples of how components shown in block form in **Figure 6** can be implemented as physical structures. Additionally, some of the components in **Figures 1-4****,** **Figure 5****,** and **Figures 7****-9** may be combined with components in **Figure 6****,** used with components in **Figure 6****,** or a combination of the two.

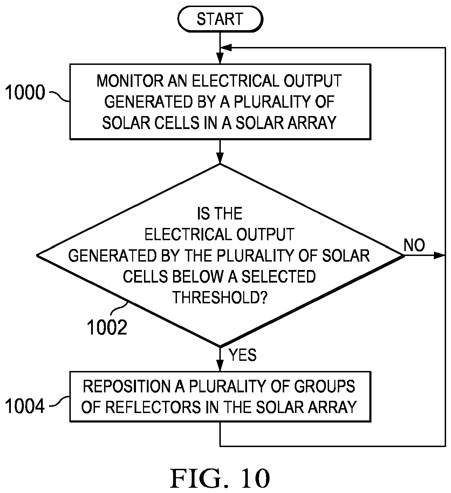

With reference now to **Figure 10****,** an illustration of a process for focusing light onto a plurality of solar cells is depicted in the form of a flowchart in accordance with an illustrative embodiment. The process illustrated in **Figure 10** may be used to, for example, focus a beam of light onto a plurality of solar cells, such as plurality of solar cells **606** in **Figure 6****.**

The process may begin by monitoring an electrical output generated by a plurality of solar cells in a solar array (operation **1000**). Next, a determination may be made as to whether the electrical output generated by the plurality of solar cells is below a selected threshold (operation **1002**). If the electrical output generated by the plurality of solar cells is below the selected threshold, a plurality of groups of reflectors in the solar array are repositioned (operation **1004**), with the process then returning to operation **1000** as described above. Otherwise, if the electrical output generated by the plurality of solar cells is not below the selected threshold, the process returns to operation **1000** as described above.

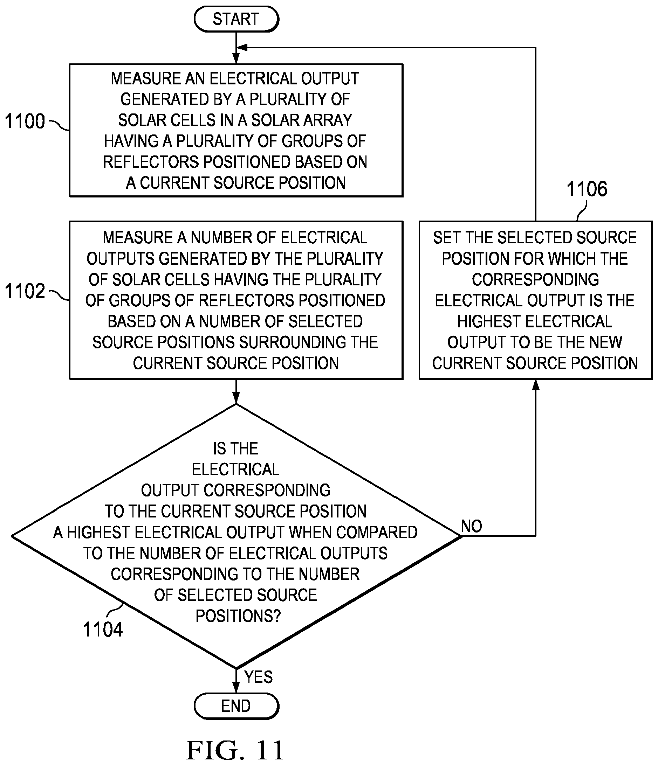

With reference now to **Figure 11****,** an illustration of a process for focusing light onto a solar cell is depicted in the form of a flowchart in accordance with an illustrative embodiment. The process illustrated in **Figure 11** may be used to, for example, focus a beam of light onto a plurality of solar cells, such as plurality of solar cells **606** in

### Figure 6.

The process may begin by measuring an electrical output generated by a plurality of solar cells in a solar array having a plurality of groups of reflectors positioned based on a current source position (operation **1100**). In operation **1100,** the current source position may be defined as (θ_{focus}, φ_{focus}). In this manner, the current source position may be an angular position with respect to an axis that is substantially perpendicular to the solar array. Each reflector in each group of reflectors in the plurality of groups of reflectors may be positioned to reflect a beam of light being directed from this current source position to the solar cell of the plurality of solar cells corresponding to that reflector.

Next, a number of electrical outputs generated by the plurality of solar cells having the plurality of groups of reflectors positioned based on a number of selected source positions surrounding the current source position are measured (operation **1102**)**.** In operation **1102,** the plurality of groups of reflectors may be repositioned based on a particular one of the number of selected source positions. The electrical output generated by the plurality of solar cells with the plurality of groups of reflectors being positioned based on this particular selected source position is measured. This process may be repeated for each of the number of selected source positions.

The number of selected source positions may include, for example, 8 positions. These 8 positions may include the following positions: (θ_{focus}+Δθ, φ_{focus}+Δφ), (θ_{focus}+Δθ, φ_{focus}-Δφ), (θ_{focus}-Δθ, φ_{focus}+Δφ), (θ_{focus}-Δθ, φ_{focus}-Δφ), (θ_{focus}, φ_{focus}+Δφ), (θ_{focus}, φ_{focus}-Δφ), (θ_{focus}+Δθ, φ_{focus}), and (θ_{focus}-Δθ, φ_{focus}). In other examples, some other number of selected source positions may be selected. For example, 4, 7, 9, 12, 20, or some other number of positions may be selected.

Thereafter, a determination is made as to whether the electrical output corresponding to the current source position is a highest electrical output when compared to the number of electrical outputs corresponding to the number of selected source positions (operation **1104**). In particular, in operation **1104,** the determination is made as to whether the electrical output corresponding to the current source position or the electrical output corresponding to one of the number of selected source positions is a highest electrical output.

If the electrical output corresponding to the current source position is the highest electrical output, the process terminates. Otherwise, the selected source position of the number of selected source positions for which the corresponding electrical output is the highest electrical output is set to be the new current source position (operation **1106**), with the process then returning to operation **1100** as described above.

The process described in **Figure 11** may be performed repeatedly, continuously, or periodically. For example, the process described in **Figure 11** may be set to repeat at the lapse of a timer or in response to the occurrence of some event.

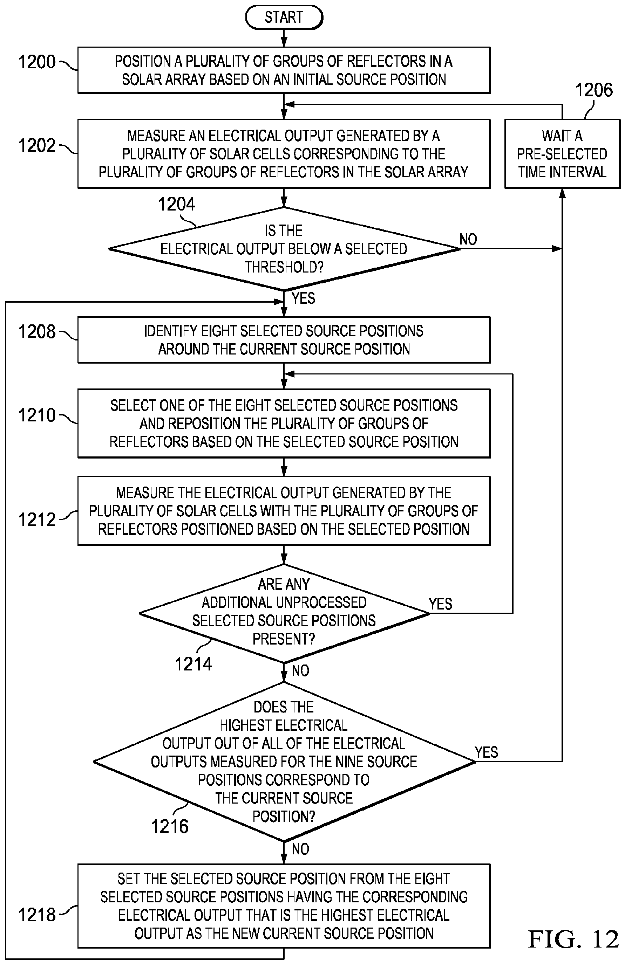

With reference now to **Figure 12****,** an illustration of a process for tracking sunlight using a solar array is depicted in the form of a flowchart in accordance with an illustrative embodiment. The process illustrated in **Figure 12** may be implemented to track sunlight using, for example, solar array **604** in **Figure 6****.** A similar process may be used to track sunlight using a set of solar arrays, such as set of solar arrays **602** in **Figure 6****.**

The process may begin by positioning a plurality of groups of reflectors in a solar array based on an initial source position (operation **1200**). The initial source position, (θ, φ) may be, for example, (0, 0). The initial source position may be the angular position relative to an axis substantially perpendicular to the solar array at which the sun is thought to be positioned. Positioning the plurality of groups of reflectors in operation **1200** may include applying a voltage to the actuation device corresponding to each reflector in the plurality of groups of reflectors such that each reflector is tilted in a manner that enables the highest concentration of light to be focused onto a corresponding solar cell in a plurality of solar cells in the solar array given the assumption that the source of the light is actually at the initial source position.

Next, an electrical output generated by the plurality of solar cells corresponding to the plurality of groups of reflectors in the solar array is measured (operation **1202**). A determination is made as to whether the electrical output is below a selected threshold (operation **1204**). If the electrical output is not below the selected threshold, the process waits a pre-selected time interval (operation **1206**), with the process then returning to operation **1202** as described above.

With reference again to operation **1204,** if the electrical output is below the selected threshold, 8 selected source positions around the current source position are identified (operation **1208**). In one illustrative example, the 8 selected source positions may be 1 degree offsets from the current source position (θ, φ). For example, the 8 selected source positions may be (θ-1°, φ-1°), (θ+1°, φ-1°), (θ+1°, φ+1°), (θ+1°, φ+1°), (θ, φ-1°), (θ, φ+1°), (θ-1°, φ), and (θ+1°, φ).

Thereafter, one of the 8 selected source positions is selected and the plurality of groups of reflectors is repositioned based on the selected source position (operation **1210**). Next, the electrical output generated by the plurality of solar cells is measured with the plurality of groups of reflectors positioned based on the selected source position (operation **1212**). The process then determines whether any additional unprocessed selected source positions are present (operation **1214**). If any additional unprocessed selected source positions are present, the process returns to operation **1210.** Otherwise, the process determines whether the highest electrical output out of all the electrical outputs measured for the 9 source positions corresponds to the current source position (operation **1216**). The 9 source positions include the 8 selected source positions and the current source position.

If the highest electrical output out of all of the electrical outputs measured for the 9 source positions corresponds to the current source position, the process proceeds to operation **1206** as described above. Otherwise, the selected source position from the 8 selected source positions having the corresponding electrical output that is the highest electrical output is set as the new current source position (operation **1218**), with the process then returning to operation **1208** as described above.

The flowcharts and block diagrams in the different depicted embodiments illustrate the architecture, functionality, and operation of some possible implementations of apparatuses and methods in an illustrative embodiment. In this regard, each block in the flowcharts or block diagrams may represent a module, a segment, a function, a portion of an operation or step, some combination thereof.

In some alternative implementations of an illustrative embodiment, the function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram.

The description of the different illustrative embodiments has been presented for purposes of illustration and description, and is not intended to be exhaustive or limited to the embodiments in the form disclosed. Many modifications and variations will be apparent to those of ordinary skill in the art. Further, different illustrative embodiments may provide different features as compared to other desirable embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. An apparatus comprising:
a plurality of solar cells (606);
a plurality of groups of reflectors (608) corresponding to the plurality of solar cells (606), an actuation device being provided for each reflector for tilting said reflector about two axes of rotation; and
a control module (618) in communication with the plurality of solar cells (606) and the plurality of groups of reflectors (608), wherein the control module (618) includes control logic (620) adapted to monitor an electrical output (622) from the plurality of solar cells (606) and to reposition the plurality of groups of reflectors (608) when the electrical output (622) is below a selected threshold (624), to ensure the electrical output of the solar cells is kept at or above the selected threshold,
wherein said control logic (620) is adapted to position the plurality of reflectors based on a current source position defined as an angular position (θ, φ) with respect to an axis that is substantially perpendicular to the plurality of solar cells (606),
wherein, when the electrical output from the plurality of solar cells (606) is below said threshold said control logic (620) is adapted to identify a number of selected source positions around the current source position with each of the identified number of selected source positions having an angular offset Δθ, Δφ from the angular position of the current source, wherein, said control logic (620) is adapted to reposition the plurality of group of reflectors for each of selected source positions and measure the electrical output generated by the plurality of solar cells in each selected source position,
wherein, said control logic (620) is adapted to determine whether the electrical output corresponding to the current source position or the electrical output corresponding to one of the number of selected source positions is a highest electrical output,
wherein, said control logic (620) is adapted to respond to the determination that the highest measured electrical output of the selected source positions is higher than the current source position and set the selected source position with the highest output as a new source position,
wherein, said control logic (620) is adapted to reposition the plurality of group of reflectors (608) based on the new current source position.

2. The apparatus of claim 2 wherein the number of identified selected source positions is 4, 7, 8, 9, 12 or 20.

3. The apparatus of claim 2 wherein 8 selected source positions around the current source position are identified each with 1 degree offsets from the current source position (θ, φ) and the selected source positions are (θ-1°, φ-1°), (θ+1°, φ-1°), (θ+1°, φ+1°), (θ+1°, φ+1°), (θ, φ-1°), (θ, φ+1°), (θ-1°, φ), and (θ+1°, φ).

4. The apparatus of claim 1 to 3 further comprising:
a coverglass (615), wherein the plurality of solar cells (606) are mounted to the coverglass (615).

5. The apparatus of claim 4, wherein the plurality of solar cells (606) are mounted to the coverglass (615) using a plurality of interconnects (706).

6. The apparatus of claim 1, wherein each reflector in the plurality of groups of reflectors (608) is a micro-electromechanical systems based reflector.

7. The apparatus of any of the preceding claims further comprising:
a substrate (609), wherein the plurality of groups of reflectors (608) are supported by the substrate (609).

8. A method for focusing light (610) onto a plurality of solar cells (606) in an apparatus according to any one of claims 1-7, the method comprising:
monitoring (1000) an electrical output (622) generated by the plurality of solar cells (606);
determining (1002) whether the electrical output (622) is below a selected threshold (624); and
repositioning (1004) said plurality of groups of reflectors (608) in response to a determination that the electrical output (622) is below the selected threshold (624) using control logic (620) in the control module (618) to ensure that electrical output of the solar cells is kept at or above the selected threshold,
wherein monitoring (1000) the electrical output (622) comprises:
measuring (1100) the electrical output (622) generated by the plurality of solar cells (606) with the plurality of groups of reflectors (608) positioned based on a current source position,
wherein repositioning (1004) the plurality of groups of reflectors (608) comprises:
identifying a number of selected source positions around the current source position with each of the identified selected source positions having an angular offset Δθ, Δφ from the angular position of the current source,
measuring (1102) said number of electrical outputs generated by the plurality of solar cells (606) having the plurality of groups of reflectors (608) positioned based on the number of selected source positions surrounding the current source position,
determining (1104) whether the electrical output (622) corresponding to the current source position is the highest electrical output when compared to said number of electrical outputs corresponding to the number of selected source positions,
responsive to a determination that the electrical output (622) corresponding to the current source position is not the highest electrical output, setting (1106) a selected source position out of the number of selected source positions for which a corresponding electrical output (622) is the highest electrical output to be a new current source position,
repositioning the plurality of groups of reflectors (608) based on the new current source position.

9. The method of claim 8 further comprising:
reflecting the light (610) using the plurality of groups of reflectors (608) to focus the light (610) onto the plurality of solar cells (606).

10. The method of claim 9, wherein reflecting the light (610) comprises:
reflecting the light (610) using a group of reflectors (614) in the plurality of groups of reflectors (608) to focus the light (610) onto a focal point (613) of a corresponding solar cell (612) of the plurality of solar cells (606).

11. The method of claim 8, wherein repositioning the plurality of groups of reflectors (608) comprises:
adjusting a voltage applied to an actuation device corresponding to at least one reflector in the plurality of groups of reflectors (608).

12. A solar array system (600) comprising:
a set (602) of solar arrays of an apparatus according to any one of claims 1-3

13. The solar array system (600) of claim 12, wherein the each solar array (604) further comprises:
a coverglass (615); and
a plurality of interconnects (706), wherein the plurality of solar cells (606) are mounted onto the coverglass (615) using the plurality of interconnects (706).

14. The solar array system (600) of claim 12 or 13, wherein the each solar array (604) further comprises:
a substrate (609) that supports the plurality of groups of reflectors (608).

15. The solar array system (600) of claim 12, wherein each reflector in the plurality of groups of reflectors (608) is a micro-electromechanical systems based reflector.

## Patentansprüche

1. Vorrichtung, die aufweist:
eine Mehrzahl von Solarzellen (606);
eine Mehrzahl von Gruppen von Reflektoren (608), der Mehrzahl der Solarzellen (606) zugehörig, wobei eine Betätigungsvorrichtung für jeden Reflektor vorgesehen ist, um den Reflektor um zwei Rotationsachsen zu neigen; und
ein Steuermodul (618) in Kommunikation mit der Mehrzahl von Solarzellen (606) und der Mehrzahl von Gruppen von Reflektoren (608),
wobei das Steuermodul (618) Steuerlogik (620) aufweist, die dazu ausgebildet ist,
eine elektrische Ausgangsleistung (622) von der Mehrzahl von Solarzellen (606) zu überwachen und die Mehrzahl von Gruppen von Reflektoren (608) neu zu positionieren, wenn die elektrische Ausgangsleistung (622) unter einem ausgewählten Grenzwert (624) liegt, um sicherzustellen, dass die elektrische Ausgangsleistung der Solarzellen an oder über dem ausgewählten Grenzwert beibehalten wird,
wobei die Steuerlogik (620) dazu ausgebildet ist, die Mehrzahl von Reflektoren basierend auf einer aktuellen Ausgangsposition zu positionieren, die als Winkelposition (θ, φ) bezüglich einer Achse definiert ist, die im Wesentlichen senkrecht zur Mehrzahl von Solarzellen (606) ist,
wobei, wenn die elektrische Ausgangsleistung von der Mehrzahl von Solarzellen (606) unter dem Grenzwert liegt, die Steuerlogik (620) dazu ausgebildet ist, eine Anzahl von ausgewählten Ausgangspositionen um die aktuelle Ausgangsposition zu identifizieren, wobei eine jede der identifizierten Anzahl von ausgewählten Ausgangspositionen einen Winkelversatz Δθ, Δφ von der Winkelposition der aktuellen Ausgangsposition hat,
wobei die Steuerlogik (620) dazu ausgebildet ist, die Mehrzahl von Gruppen von Reflektoren für jede der ausgewählten Ausgangspositionen neu zu positionieren und die elektrische Ausgangsleistung zu messen, die von der Mehrzahl von Solarzellen an einer jeden ausgewählten Ausgangsposition erzeugt wird,
wobei die Steuerlogik (620) dazu ausgebildet ist, zu bestimmen, ob die elektrische Ausgangsleistung, eine der aktuellen Ausgangsposition entspricht, oder die elektrische Ausgangsleistung, die einer von der Anzahl der ausgewählten Ausgangspositionen entspricht, eine höchste elektrische Ausgangsleistung ist,
wobei die Steuerlogik (620) dazu ausgebildet ist, auf die Bestimmung zu reagieren, dass die höchste gemessene elektrische Ausgangsleistung der ausgewählten Ausgangspositionen höher ist als die der aktuellen Ausgangsposition und die ausgewählte Ausgangsposition mit der höchsten Ausgangsleistung als eine neue Ausgangsposition festzulegen,
wobei die Steuerlogik (620) dazu ausgebildet ist, die Mehrzahl von Gruppen von Reflektoren (608) basierend auf der neuen aktuellen Ausgangsposition neu zu positionieren.

2. Vorrichtung nach Anspruch 2, wobei die Anzahl der identifizierten ausgewählten Ausgangspositionen 4, 7, 8, 9, 12 oder 20 ist.

3. Vorrichtung nach Anspruch 2, wobei acht ausgewählte Ausgangspositionen um die aktuelle Ausgangsposition jeweils mit 1° Versatz von der aktuellen Ausgangsposition (θ, φ) identifiziert werden, und die ausgewählten Ausgangspositionen
(θ -1°, φ - 1°), (θ + 1°, φ - 1°), (θ + 1°, φ + 1°), (θ - 1°, φ + 1°), (θ, φ -1°),
(θ, φ + 1°), (θ - 1°, φ) und (θ + 1°, φ) sind.

4. Vorrichtung nach Anspruch 1 bis 3, die weiterhin aufweist:
ein Abdeckungsglas (615), wobei die Mehrzahl von Solarzellen (606) am Abdeckungsglas (615) angebracht sind.

5. Vorrichtung nach Anspruch 4, wobei die Mehrzahl von Solarzellen (606) am Abdeckungsglas (615) mittels einer Mehrzahl von Verbindungselementen (706) angebracht sind.

6. Vorrichtung nach Anspruch 1, wobei jeder Reflektor in der Mehrzahl von Gruppen von Reflektoren (608) ein auf mikroelektromechanischen Systemen basierender Reflektor ist.

7. Vorrichtung nach einem der vorhergehenden Ansprüche, die weiterhin aufweist:
ein Substrat (609), wobei die Mehrzahl von Gruppen von Reflektoren (608) vom Substrat (609) gehalten werden.

8. Verfahren zum Fokussieren von Licht (610) auf eine Mehrzahl von Solarzellen (606) in einer Vorrichtung nach einem der Ansprüche 1 bis 7, wobei das Verfahren aufweist:
Überwachen (1000) einer elektrischen Ausgangsleistung (622), die von der Mehrzahl von Solarzellen (606) erzeugt wird;
Bestimmen (1002), ob die elektrische Ausgangsleistung (622) unter einem ausgewählten Grenzwert (624) liegt; und
Neupositionieren (1004) der Mehrzahl von Gruppen von Reflektoren (608) in Reaktion auf eine Bestimmung mittels Steuerlogik (620) im Steuermodul (618), dass die elektrische Ausgangsleistung (622) unter dem ausgewählten Grenzwert (624) liegt, um sicherzustellen, dass die elektrische Ausgangsleistung der Solarzellen an oder über dem ausgewählten Grenzwert beibehalten wird,
wobei das Überwachen (1000) der elektrischen Ausgangsleistung (622) aufweist:
Messen (1100) der elektrischen Ausgangsleistung (622), die von der Mehrzahl von Solarzellen (606) mit der Mehrzahl von Gruppen von Reflektoren (608), die basierend auf einer aktuellen Ausgangsposition positioniert sind, erzeugt wird,
und wobei das Neupositionieren (1004) der Mehrzahl von Gruppen von Reflektoren (608) aufweist:
Identifizieren einer Anzahl von ausgewählten Ausgangspositionen um die aktuelle Ausgangsposition, wobei eine jede der identifizierten ausgewählten Ausgangspositionen einen Winkelversatz Δθ, Δφ von der Winkelposition der aktuellen Ausgangsposition hat,
Messen (1102) der Anzahl der elektrischen Ausgangsleistungen, die von der Mehrzahl von Solarzellen (606) mit der Mehrzahl von Gruppen von Reflektoren (608), die basierend auf der Anzahl der Ausgangspositionen, die die aktuelle Ausgangsposition umgeben, positioniert sind, erzeugt werden,
Bestimmen (1104), ob die elektrische Ausgangsleistung (622), die der aktuellen Ausgangsposition entspricht, die höchste elektrische Ausgangsleistung im Vergleich zu der Anzahl der elektrischen Ausgangsleistungen ist, die der Anzahl der ausgewählten Ausgangspositionen entspricht,
in Reaktion auf eine Bestimmung, dass die elektrische Ausgangsleistung (622), die der aktuellen Ausgangsposition entspricht, nicht die höchste elektrische Ausgangsleistung ist, Festlegen (1106) einer ausgewählten Ausgangsposition aus der Anzahl der ausgewählten Ausgangspositionen, für die eine entsprechende elektrische Ausgangsleistung (622) die höchste elektrische Ausgangsleistung ist, als eine neue aktuelle Ausgangsposition,
Neupositionieren der Mehrzahl von Gruppen von Reflektoren (608) basierend auf der neuen aktuellen Ausgangsposition.

9. Verfahren nach Anspruch 8, das weiterhin aufweist:
Reflektieren des Lichts (610) mittels der Mehrzahl von Gruppen von Reflektoren (608), um das Licht (610) auf der Mehrzahl von Solarzellen (606) zu fokussieren.

10. Verfahren nach Anspruch 9, wobei das Reflektieren des Lichts (610) aufweist:
Reflektieren des Lichts (610) mittels einer Gruppe von Reflektoren (614) in der Mehrzahl von Gruppen von Reflektoren (608), um das Licht (610) auf einen Fokuspunkt (613) einer zugehörigen Solarzelle (612) der Mehrzahl von Solarzellen (606) zu fokussieren.

11. Verfahren nach Anspruch 8, wobei das Neupositionieren der Mehrzahl von Gruppen von Reflektoren (608) aufweist:
Anpassen einer Spannung, die auf eine Betätigungsvorrichtung, die wenigstens einem Reflektor der Mehrzahl von Gruppen von Reflektoren (608) zugehörig ist, angelegt wird.

12. Solarzellengruppensystem (600), das aufweist:
einen Satz (602) von Solarzellengruppen einer Vorrichtung gemäß einem der Ansprüche 1 bis 3.

13. Solarzellengruppensystem (600) nach Anspruch 12, wobei eine jede Solarzellengruppe (604) weiterhin aufweist:
ein Abdeckungsglas (615); und
eine Mehrzahl von Verbindungselementen (706), wobei die Mehrzahl von Solarzellen (606) am Abdeckungsglas (615) mittels der Mehrzahl von Verbindungselementen (706) angebracht sind.

14. Solarzellengruppensystem (600) nach Anspruch 12 oder 13, wobei eine jede Solarzellengruppe (604) weiterhin aufweist:
ein Substrat (609), das die Mehrzahl von Gruppen von Reflektoren (608) hält.

15. Solarzellengruppensystem (600) nach Anspruch 12, wobei jeder Reflektor in der Mehrzahl von Gruppen von Reflektoren (608) ein auf mikroelektromechanischen Systemen basierender Reflektor ist.

## Revendications

1. Appareil comprenant :
une pluralité de cellules solaires (606) ;
une pluralité de groupes de réflecteurs (608) correspondant à la pluralité de cellules solaires (606), un dispositif d'actionnement étant fourni pour chaque réflecteur pour incliner ledit réflecteur autour de deux axes de rotation ; et
un module de commande (618) en communication avec la pluralité de cellules solaires (606) et la pluralité de groupes de réflecteurs (608),
dans lequel le module de commande (618) inclut une logique de commande (620) adaptée pour surveiller une puissance électrique (622) provenant de la pluralité de cellules solaires (606) et pour repositionner la pluralité de groupes de réflecteurs (608) lorsque la puissance électrique (622) est inférieure à un seuil sélectionné (624), pour garantir que la puissance électrique des cellules solaires est maintenue au niveau ou au-dessus du seuil sélectionné,
dans lequel ladite logique de commande (620) est adaptée pour positionner la pluralité de réflecteurs sur la base d'une position de source de courant en tant que position angulaire (θ, Φ) par rapport à un axe qui est sensiblement perpendiculaire à la pluralité de cellules solaires (606),
dans lequel, lorsque la puissance électrique provenant de la pluralité de cellules solaires (606) est inférieure audit seuil, ladite logique de commande (620) est adaptée pour identifier un nombre de positions de source sélectionnées autour de la position de source de courant avec chacun du nombre identifié de positions de source sélectionnées ayant un décalage angulaire Δθ, ΔΦ par rapport à la position angulaire de la source de courant,
dans lequel ladite logique de commande (620) est adaptée pour repositionner la pluralité de groupes de réflecteurs pour chacune des positions de source sélectionnées et mesurer la puissance électrique générée par la pluralité de cellules solaires dans chaque position de source sélectionnée,
dans lequel ladite logique de commande (620) est adaptée pour déterminer si la puissance électrique correspondant à la position de source de courant ou la puissance électrique correspondant à l'une du nombre de positions de source sélectionnées est une puissance électrique maximale,
dans lequel ladite logique de commande (620) est adaptée pour répondre à la détermination que la puissance électrique mesurée maximale des positions de source sélectionnées est supérieure à la position de source de courant et régler la position de source sélectionnée ayant la puissance maximale en tant que nouvelle position de source,
dans lequel ladite logique de commande (620) est adaptée pour repositionner la pluralité de groupes de réflecteurs (608) sur la base de la nouvelle position de source de courant.

2. Appareil selon la revendication 2 dans lequel le nombre de positions de source sélectionnées identifiées est de 4, 7, 8, 9, 12 ou 20.

3. Appareil selon la revendication 2 dans lequel 8 positions de source sélectionnées autour de la position de source de courant sont identifiées chacune avec des décalages de 1 degré par rapport à la position de source de courant (θ, Φ) et les positions de source sélectionnées sont (θ-1°, Φ-1°), (θ+1°, Φ-1°), (θ+1°, Φ+1°), (θ+1°, Φ+1°), (θ, Φ-1°), (θ, Φ+1°), (θ-1°, Φ) et (θ+1°, Φ).

4. Appareil selon la revendication 1 à 3 comprenant en outre :
un verre couvrant (615), dans lequel la pluralité de cellules solaires (606) sont montées sur le verre couvrant (615).

5. Appareil selon la revendication 4, dans lequel la pluralité de cellules solaires (606) sont montées sur le verre couvrant (615) en utilisant une pluralité d'interconnexions (706).

6. Appareil selon la revendication 1, dans lequel chaque réflecteur dans la pluralité de groupes de réflecteurs (608) est un réflecteur basé sur des systèmes micro-électromécaniques.

7. Appareil selon l'une quelconque des revendications précédentes comprenant en outre :
un substrat (609), dans lequel la pluralité de groupes de réflecteurs (608) sont supportés par le substrat (609).

8. Procédé de focalisation de lumière (610) sur une pluralité de cellules solaires (606) dans un appareil selon l'une quelconque des revendications 1 à 7, le procédé comprenant :
la surveillance (1000) d'une puissance électrique (622) générée par la pluralité de cellules solaires (606) ;
le fait de déterminer (1002) si la puissance électrique (622) est inférieure à un seuil sélectionné (624) ; et
le repositionnement (1004) de ladite pluralité de groupes de réflecteurs (608) en réponse à une détermination que la puissance électrique (622) est inférieure au seuil sélectionné (624) en utilisant une logique de commande (620) dans le module de commande (618) pour garantir que la puissance électrique des cellules solaires est maintenue au niveau ou au-dessus du seuil sélectionné,
dans lequel la surveillance (1000) de la puissance électrique (622) comprend :
la mesure (1100) de la puissance électrique (622) générée par la pluralité de cellules solaires (606) avec la pluralité de groupes de réflecteurs (608) positionnés sur la base d'une position de source de courant,
et dans lequel le repositionnement (1004) de la pluralité de groupes de réflecteurs (608) comprend :
l'identification d'un nombre de positions de source sélectionnées autour de la position de source de courant avec chacune des positions de source sélectionnées identifiées ayant un décalage angulaire Δθ, ΔΦ par rapport à la position angulaire de la source de courant,
la mesure (1102) dudit nombre de puissances électriques générées par la pluralité de cellules solaires (606) ayant la pluralité de groupes de réflecteurs (608) positionnés sur la base du nombre de positions de source sélectionnées entourant la position de source de courant,
le fait de déterminer (1104) si la puissance électrique (622) correspondant à la position de source de courant est la puissance électrique maximale comparativement audit nombre de puissances électriques correspondant au nombre de positions de source sélectionnées,
en réponse à une détermination que la puissance électrique (622) correspondant à la position de source de courant n'est pas la puissance électrique maximale, le réglage (1106) d'une position de source sélectionnée parmi le nombre de positions de source sélectionnées pour laquelle une puissance électrique (622) correspondante est la puissance électrique maximale devant être une nouvelle position de source de courant,
le repositionnement de la pluralité de groupes de réflecteurs (608) sur la base de la nouvelle position de source de courant.

9. Procédé selon la revendication 8 comprenant en outre :
le réfléchissement de la lumière (610) en utilisant la pluralité de groupes de réflecteurs (608) pour focaliser la lumière (610) sur la pluralité de cellules solaires (606).

10. Procédé selon la revendication 9, dans lequel le réfléchissement de la lumière (610) comprend :
le réfléchissement de la lumière (610) en utilisant un groupe de réflecteurs (614) dans la pluralité de groupes de réflecteurs (608) pour focaliser la lumière (610) sur un point focal (613) d'une cellule solaire (612) correspondante de la pluralité de cellules solaires (606).

11. Procédé selon la revendication 8, dans lequel le repositionnement de la pluralité de groupes de réflecteurs (608) comprend :
l'ajustement d'une tension appliquée sur un dispositif d'actionnement correspondant à au moins un réflecteur dans la pluralité de groupes de réflecteurs (608).

12. Système de réseau solaire (600) comprenant :
un ensemble (602) de réseaux solaires d'un appareil selon l'une quelconque des revendications 1 à 3

13. Système de réseau solaire (600) selon la revendication 12, dans lequel le chaque réseau solaire (604) comprend en outre :
un verre couvrant (615) ; et
une pluralité d'interconnexions (706), dans lequel la pluralité de cellules solaires (606) sont montées sur le verre couvrant (615) en utilisant la pluralité d'interconnexions (706).

14. Système de réseau solaire (600) selon la revendication 12 ou 13, dans lequel le chaque réseau solaire (604) comprend en outre :
un substrat (609) qui supporte la pluralité de groupes de réflecteurs (608).

15. Système de réseau solaire (600) selon la revendication 12, dans lequel chaque réflecteur dans la pluralité de groupes de réflecteurs (608) est un réflecteur basé sur des systèmes micro-électromécaniques.
